## Europäisches Patentamt

## European Patent Office

## Office européen des brevets

(19)

(11) Veröffentlichungsnummer: **0 119 586**

**B1**

(12)  **EUROPÄISCHE PATENTSCHRIFT**

(45) Veröffentlichungstag der Patentschrift: **09.01.91**

(51) Int. Cl.⁵: **H 03 M 1/00**

(21) Anmeldenummer: **84102760.0**

(22) Anmeldetag: **14.03.84**

(54) Verfahren und Vorrichtung zur schnellen und hochauflösenden Digitalisierung von analogen Signalen.

(30) Priorität: **22.03.83 DE 3310245**

(43) Veröffentlichungstag der Anmeldung:
**26.09.84 Patentblatt 84/39**

(45) Bekanntmachung des Hinweises auf die
Patenterteilung:
**09.01.91 Patentblatt 91/02**

(84) Benannte Vertragsstaaten:
**GB SE**

(56) Entgegenhaltungen:
**FR-A-2 296 942**
**US-A-2 949 602**

**A. Barone, G. Paterno "Physics and Applications
of the Josephson Effect", John Wiley & Sons,
New York 1982, Seiten 383-415**

(73) Patentinhaber: **DORNIER GMBH**
**Postfach 1420**
**D-7990 Friedrichshafen 1 (DE)**

(72) Erfinder: **Ludwig, Wolfgang, Dr.**
**Elblingweg 15**
**D-7758 Meersburg (DE)**

(74) Vertreter: **Landsmann, Ralf, Dipl.-Ing.**
**c/o DORNIER GMBH Postfach 1420**
**D-7990 Friedrichshafen 1 (DE)**

**Beschreibung**

Die Erfindung betrifft ein Verfahren zur schnellen und hochauflösenden Digitalisierung von analogen Signalen mit Hilfe eines supraleitenden Analog-Digital-(AD)-Wandlers, nach dem Oberbegriff des Anspruchs 1.

Als supraleitende Analog-Digital-Wandler werden Josephson-Kontakte verwendet, deren grundlegende Eigenschaft es ist, bei einer angelegten Spannung von bis zu einigen mV eine dieser Spannung äquivalente Frequenz bis in den Gigahertz-Bereich zu erzeugen. Diese Elemente sind z.B. wesentlicher Bestandteil von supraleitenden Spannungsreferenzen. Josephson-Kontakte und deren Anwendung sind aus der Literatur bekannt, z.B. ist in "Tieftemperatur Technologie", Hartmut Frey, René A. Haefer, Herausgeber F.X. Eder, VDI-Verlag (1981) auf Seite 419 bis 432 die Anwendung solcher Kontakte für supraleitende Quanten-Interferometer (SQUID=Superconducting Quantum Interference Device) beschrieben.

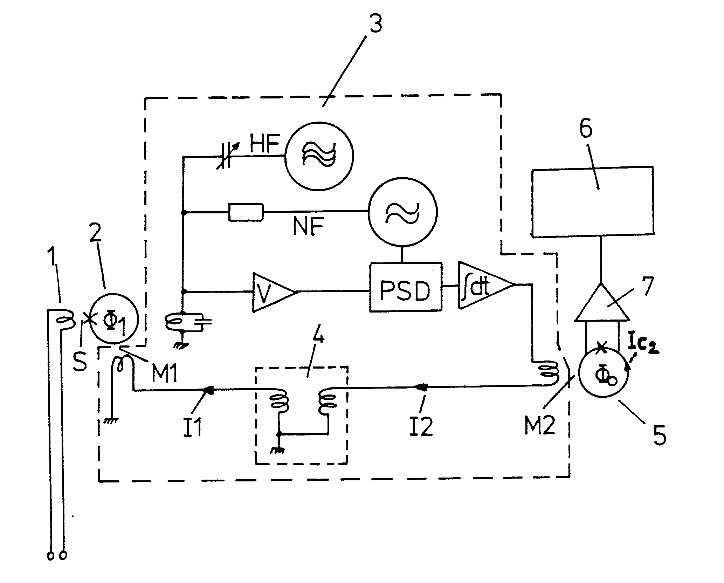

Aus dem Buch "Physics and Applications of the Josephson Effect" von A. Barone und G. Paterno, Verlag John Wiley & Sons (1982), Seiten 401 bis 403, insbesondere Fig. 13.14, ist eine Vorrichtung zur schnellen Digitalisierung von analogen Signalen mit hilfe eines supraleitenden Analog-Digital-Wandlers bekannt. Dabei werden die Signale über einen Flußübertrager in ein als Nullpunktdetektor ausgebildetes SQUID eingekoppelt, welches über einen Gegenkopplungskreis den magnetischen Fluß im SQUID konstant hält. Dabei enthält der Gegenkopplungskreis einen Hochfrequenzgenerator, der über einen Koppelkondensator ein HF-Signal in einen Schwingkreis einkoppelt, dessen Spule einen Fluß im SQUID erzeugt, wobei der Nullpunkt dieses HF-Flusses durch ein NF-Signal periodisch verschoben wird. Dabei wird mittels eines phasenselektiven Detektors das durch die Gegeninduktivität erzeugte Feld geregelt.

Aufgabe der Erfindung ist es, einen AD-Wandler zu schaffen, der sowohl einen sehr hohen Dynamikbereich, als auch eine hohe Auflösung von Bruchteilen eines Flußquantes und eine hohe Meßgeschwindigkeit besitzt und welcher aufgrund seiner Präzision und Geschwindigkeit in spezieller Meßtechnik, z.B. für Anwendung im Ultraschallbereich oder Radarbereich einsetzbar ist.

Zur Lösung der gestellten Aufgabe sind erfindungsgemäss die kennzeichnenden Merkmale von Anspruch 1 und die des ihm folgenden Unteranspruches vorgesehen.

Der Vorteil der Erfindung besteht darin, dass durch Verwendung von zwei SQUID's, von denen das eine als Nullpunktdetektor und das andere als Quantenzähler wirken, eine Digitalisierung mit einer Flußauflösung von 24—27 bit bzw. 140—160 dB erreicht wird.

Da hierbei die Zählung im GHz-Bereich erfolgt, liegen alle 27 bit parallel vor und können somit parallel ausgelesen werden; damit liegt die Wandlungsrate bei kleinen Änderungen im GHz-Bereich. Die maximale Geschwindigkeit ist gegeben durch das Verhältnis vom Dynamikbereich zur Zählfrequenz. Zum Beispiel erlaubt eine Zählfrequenz von 2 GHz einen Dynamikbereich von 140 dB in 5 msec zu erfassen. Ein Dynamikbereich von 160 dB erfordert eine Zeit von 50 msec.

Durch Einkopplung von analogen Signalen über einen Flußübertrager in ein als Nullpunktdetektor ausgebildetes SQUID SQ1 wird über eine Gegeninduktivität durch den Strom $I_1$ im SQUID SQ1 ein Gegenkopplungsfluß so eingekoppelt, dass der Gesamtfluß im SQUID SQ1 konstant bleibt. Der Strom $I_1$ entsteht durch einen spuraleitenden Transformator aus einem darin fliessenden zu $I_1$ proportionalen Strom $I_2$, welcher über eine Gegeninduktivität in einem als Quantenzähler ausgebildeten SQUID SQ2 nach Erreichen eines kritischen Stromes $I_{c2}$ Quantensprünge erzeugt. Diese Quantensprünge werden nach Durchlaufen eines Verstärkers in einem Vor-Rückwärts-Zähler gezählt. Das Verhältnis der beiden Ströme $I_1$ und $I_2$ wird durch den supraleitenden Transformator und die Gegeninduktivitäten der beiden SQUID SQ1 und SQ2 so eingestellt, dass eine etwa der Stromauflösung von SQUID SQ1 entsprechende Änderung durch eine Stromänderung $\Delta I_2$ hervorgerufen wird, die im SQUID SQ2 gerade ein Flußquant erzeugt. Der Strom $I_1$ ist dabei gegenüber dem Strom $I_2$ sehr viel kleiner, wobei das Verhältnis dieser beiden Ströme fest eingestellt und zeitlich konstant ist. In einem mit einer Schwachstelle (weak link) versehenen supraleitenden Ring, wie ihn der Nullpunktdetektor mit seinem aufgedampften supraleitenden Material (z.B. Niob) darstellt, ist der magnetische Fluß definiert durch

$$\Phi_I = \Phi_{ex} - i_s \cdot L = n \cdot \Phi_o$$

Darin bedeuten:

$\Phi_I$ = magnetischer Fluß innerhalb des supraleitenden Rings

$\Phi_{ex}$ = externer magnetischer Fluß

$i_s$ = Abschirmstrom

$L$ = Induktivität

$n$ = Anzahl der Quanten

$\Phi_o$ = Flußquant $h/2e = 2{,}07 \cdot 10^{-15}$ Vs.

Wegen der Quantisierungsbedingungen ergibt sich daraus, trägt man den magnetischen Fluß innerhalb des supraleitenden Ringes über dem externen magnetischen Fluß grafisch auf, eine Treppen- bzw. Stufenfunktion, worin die Periodizität einer Stufe ein Flußquand beträgt. Die Breite des Übergangs von einer Stufe zur anderen ist im Idealfall durch die Heisenberg'sche Unschärferelation gegeben und ist für die hohe Genauigkeit des Nullpunktdetektors ausschlaggebend.

Ein Ausführungsbeispiel ist folgend beschrieben und durche eine Skizze erläutert.

Die Figur zeigt ein Blockdiagramm, in welchem über einen Flußübertrager 1 in ein als Nullpunktdetektor ausgebildetes SQUID SQ1 2 ein Signal S eingekoppelt wird. Das SQUID SQ1 2 hält über einen Gegenkopplungskreis 3 den magnetischen Fluß konstant, in dem über eine Gegeninduktivität

$M_1$ in das SQUID SQ1 2 ein Gegenkopplungsfluß $\Phi_1$ durch einen Strom $I_1$ eingekoppelt wird. Dieser Strom $I_1$ wird durch einen im Gegenkopplungskreis 3 angeordneten supraleitenden Transformator 4 aus einem darin fliessenden Strom $I_2$ induziert. Der dabei induzierte Strom $I_1$, welcher sehr viel grösser als normal ist, weil nur ein Burchteil davon zur Gegenkopplung verwendet wird, verursacht im SQUID SQ2 Quantensprünge. Der Gegenkopplungskreis 3 besteht aus einem Hochfrequenzgenerator, der über einen kleinen Koppelkondensator ein schwaches HF-Signal in einen Schwingkreis einkoppelt, dessen Spule einen Fluß im SQUID SQ1 erzeugt. Der Nullpunkt dieses HF-Flusses wird durch ein NF-Signal periodisch verschoben, welches über einen Widerstand aus dem NF-Generator entnommen wird. Der Schwingkreis wird durch das SQUID SQ1 periodisch gedämpft, wobei die Dämpfung immer dann eintritt, wenn ein Quantenübergang stattfindet. Die Ausgangsspannung über dem Schwingkreis enthält somit die Information über die Phasenlage des Quantenüberganges in bezug auf das NF-Signal. Diese Phasenlage ist direkt proportional zum magnetischen Fluß im SQUID SQ1. In einem phasenempfindlichen Detektor wird eine Ausgangsspannung erzeugt, die proportional zur Phasenlage des Quantensprunges ist. Der nachgeschaltete Integrator erzeugt den Gegenkopplungsstrom $I_2$, der über den Transformator 4 und Strom $I_1$ den Gegenkopplungsfluß $\Phi_1$ erzeugt und der so groß gehalten wird, dass keine Flußänderung im SQUID SQ1 stattfindet. Der Quantensprung findet also immer bei gleicher Phasenlage statt. Der Strom $I_2$ erzeugt über die Gegeninduktivität $M_2$ im SQUID SQ2 5 nach Erreichen des kritischen Stromes $I_{c2}$ Quantensprünge, welche in einem damit verbundenen Vor-Rückwärts-Zähler 6 nach Durchlaufen eines Verstärkers 7 gezählt werden. Das Verhältnis der beiden Ströme $I_1$ und $I_2$ wird durch den supraleitenden Transformator 4 so eingestellt, dass eine etwa der Stromauflösung von SQUID SQ1 2 entsprechende Änderung $vI_1$ eine Stromänderung $\Delta I_2$ hervorgerufen wird, welche ihrerseits im SQUID SQ2 5 ein Flußquant $\Phi_0$ erzeugt. Dabei ist der Strom $I_1$ gegenüber dem Strom $I_2$ sehr viel kleiner und das Verhältnis dieser beiden Ströme zueinander fest eingestellt und zeitlich konstant.

Die supraleitenden Komponenten sind das SQUID SQ1 und SQ2, der Transformator 4, Flußübertrager 1 und die Spule $M_1$. Ausserdem werden durch Helium gekühlt die Komponenten Spule $M_2$ mit Schwingkreis, eventuell der Verstärker V und der Verstärker 7.

## Patentansprüche

1. Verfahren zur schnellen und hochauflösenden Digitalisierung von analogen Signalen mit Hilfe eines supraleitenden Analog-Digital-(AD)-Wandlers, wobei die Signale über einen Flußübertrager (1) in ein als Nullpunktdetektor ausgebildetes SQUID SQ1 (2) eingekoppelt werden, welches über einen Gegenkopplungskreis (3) den magnetischen Fluß in SQUID SQ1 (2) konstant hält, wobei der Gegenkopplungskreis (3) einen Hochfrequenzgenerator enthält, der über einen Koppelkondensator ein HF-Signal in einen Schwingkreis einkoppelt, dessen Spule einen Fluß im SQUID SQ1 erzeugt, wobei der Nullpunkt dieses HF-Flusses durch ein NF-Signal periodisch verschoben wird und wobei mittels eines phasenselektiven Detektors das durch die Gegeninduktivität erzeugte Feld geregelt wird, dadurch gekennzeichnet, daß über eine Gegeninduktivität ($M_1$) in das SQUID SQ1 (2) ein Gegenkopplungsfluß $\Phi_1$ durch einen Strom $I_1$ eingekoppelt wird, der durch einen supraleitenden Transformator (4) aus einem Strom $I_2$ entsteht, welcher über eine Gegeninduktivität ($M_2$) in einem SQUID SQ2 (5) Quantensprünge erzeugt, die in einem Vor-Rückwärts-Zähler (6) nach Durchlaufen eines Verstärkers (7) gezählt werden, und daß das Verhältnis von $I_1$ zu $I_2$ durch den supraleitenden Transformator (4) und die Gegeninduktivitäten ($M_1$, $M_2$) so eingestellt wird, daß eine Änderung $\delta I_1$, die etwa der Stromauflösung vom SQUID SQ1 (2) entspricht, durch eine Stromänderung $\Delta I_2$ hervorgerufen wird, die ihrerseits ein Flußquant $\Phi_0$ im SQUID SQ2 (5) erzeugt, und daß $I_1$ sehr viel kleiner als $I_2$ ist, wobei das Verhältnis $I_1$ zu $I_2$ fest eingestellt ist.

2. Vorrichtung zur Durchführung des Verfahrens nach Anspruch 1, dadurch gekennzeichnet, daß der Nullpunktdetektor (2) ein DC-SQUID ist und der Quantenzähler SQUID SQ2 (5) eine oder mehrere Josephson-Kontakte aufweist, und daß der Transformator (4) aus einem Material hoher mechanischer Festigkeit und niedrigem thermischen Ausdehnungskoeffizienten besteht, auf welches das supraleitende Material aufgedampft wird.

## Revendications

1. Procédé de numérisation rapide et à haute résolution de signaux analogiques à l'aide d'un convertisseur analogique-numérique (AN) supraconducteur, les signaux étant appliqués par l'intermédiaire d'un transformateur de flux (1) dans un SQUID SQ1 (2) réalisé sous la forme d'un détecteur de point zéro, qui maintient constant, par l'intermédiaire d'un circuit de contre-réaction (3), le flux magnétique dans le SQUID SQ1 (2), le circuit de contre-réaction (3) contenant un générateur à haute fréquence qui applique, par l'intermédiaire d'un condensateur de couplage, un signal HF dans un circuit oscillant dont la bobine crée un flux dans le SQUID SQ1, le point zéro de ce flux HF étant décalé périodiquement par un signal NF et le champ créé par l'inductance mutuelle étant régulé au moyen d'un détecteur sélectif en phase, caractérisé en ce que, par l'intermédiaire d'une inductance mutuelle ($M_1$), un flux de contre-réaction $\Phi_1$ est appliqué au SQUID SQ1 (2) par un courant $I_1$, qui est produit grâce à un transformateur supraconducteur (4) par un courant $I_2$ qui crée des sauts quantiques par l'intermédiaire d'une inductance mutuelle (M₂) dans un SQUID SQ2 (5), qui sont comptés dans un compteur-décompteur (6) après traversée d'un amplificatuer (7), et en ce que le rapport de I₁ à I₂ est réglé par le transformateur supraconducteur (4) et les inductances mutuelles (M₁, M₂) de sorte qu'une variation δ₁ correspondant approximativement à la résolution en courant du SQUID SQ1 (2), est provoquée par une variation de courant ΔI₂, qui crée de son côté un quantum de flux Φ₀ dans le SQUID SQ2 (5), et en ce que I₁ est beaucoup plus faible que I₂, le rapport de I₁ à I₂ étant déterminé de façon fixe.

2. Dispositif pour la mise en oeuvre du procédé selon la revendication 1, caractérisé en ce que le détecteur de point zéro (2) est un SQUID à courant continu et le compteur quantique SQUID SQ2 (5) comporte une ou plusieurs jonctions Josephson, et en ce que le transformateur (4) se compose d'un matériau à haute résistance mécanique et à faible coefficient de dilatation thermique, sur lequel est vaporisé sous vide le matériau supraconducteur.

**Claims**

1. Process for fast, high resolution digitalisation of analog signals using a superconductive analog-digital (AD) converter, the signals being coupled in by means of a flux transformer 1 in a SQUID SQ1 (2) which is in the form of a zero point detector and maintains the magnetic flux in SQUID SQ1 (2) constant by means of a negative feedback circuit (3), the negative feedback circuit (3) containing a high-frequency generator which, by means of a coupling capacitor, couples a high-frequency signal into a tuned circuit, of which the inductance generates a current in the SQUID SQ1, the zero point of this high-frequency current being periodically displaced by a low frequency signal and the field generated by the mutual inductance being regulated by a phase-selective detector, characterised in that by means of a mutual inductance (M₁) in the SQUID SQ1 (2) a reverse-coupling flux Φ₁, is coupled in by a current I₁ which is generated by a superconductive transformer (4) from a current I₂ which, by means of a mutual inductance (M₂), generates quantum leaps in a SQUID SQ2 (5) which are counted in a bi-directional counter (6) after passing through an amplifier (7); and in that the ratio of I₁ to I₂ is set by means of the superconductive transformer (4) and the mutual inductances (M₁, M₂) in such a way that an alteration δI₁, which corresponds approximately to the current resolution of the SQUID SQ1 (2), is produced by a current alteration ΔI₂ which in turn generates a flux quant Φ₀ in the SQUID SQ2 (5); and in that I₁ is much smaller than I₂, the ratio of I₁ to I₂ being fixed.

2. Apparatus for performing the process according to claim 1, characterised in that the zero point detector (2) is a DC-SQUID and the quantum counter SQUID SQ2 (5) comprises one or a plurality of Josephson contacts; and in that the transformer (4) consists of a material which has a high degree of mechanical strength and low thermal expansion coefficients and onto which the superconductive material is evaporated.